# EUROPÄISCHE PATENTSCHRIFT

(11) **EP 2 314 410 B1**
(45) Veröffentlichungstag und Bekanntmachung des Hinweises auf die Patenterteilung: **17.04.2013**
(21) Anmeldenummer: 10013486.5
(22) Anmeldetag: 09.10.2010
(51) Int. Cl.: B23K 15/00, B23K 15/02, G05B 19/42, H01J 37/302

(54) **Thermisches Materialbearbeitungsverfahren durch Elektronstrahl mit Kompensierung geometrischer und magnetisch bedingter Abweichungen der Auftreffstellen des Elektronstrahles auf ein Werkstück**
Thermal material processing method with an electron beam with compensation of geometrical and magnetical errors of the positioning of the electron beam on a workpiece
Procédé de traitement de matériau thermique par faisceau d'électrons avec compensation d'erreurs géométriques et magnétiques de positionnement du fasceau d'électrons sur une pièce

(30) Priorität: 23.10.2009 DE 102009050521
(43) Veröffentlichungstag der Anmeldung: 27.04.2011
(73) Patentinhaber: pro-beam AG & Co. KGaA, 82152 Planegg (DE)
(72) Erfinder: Löwer, Thorsten, 80339 München (DE); Fath, Jürgen, 80689 München (DE)
(74) Vertreter: Ostertag, Ulrich

(56) Entgegenhaltungen:
- JP-A- 1 197 955
- US-A- 3 535 488
- US-A- 4 012 620

## Beschreibung

Die Erfindung betrifft ein Materialbearbeitungsverfahren, bei dem
a) ein Elektronenstrahl auf die Oberfläche eines Werkstücks fokussiert wird:
b) zwischen dem Arbeitsfleck des Elektronenstrahles und dem Werkstück eine Relativbewegung bewirkt wird, bei welcher der Arbeitsfleck einer Bearbeitungskontur folgt; siehe, z.B., US 3 535 488.

Die Qualität einer mit Hilfe eines Elektronenstrahls bewirkten thermischen Bearbeitung, beispielsweise einer Schweißung, hängt in großem Ausmaße davon ab, wie genau der Arbeitsfleck des Elektronenstrahls bei seiner Relativbewegung gegenüber dem Werkstück die gewünschte Bearbeitungskontur, im Falle der Verschweißung zweier Bauteile den Fugenverlauf zwischen den zu verschweißenden Bauteilen, trifft. Bei bekannten Materialbearbeitungsverfahren der eingangs genannten Art kommt es aus unterschiedlichen Gründen diesbezüglich zu Ungenauigkeiten. Ein erster Grund liegt in geometrischen Abweichungen zwischen der tatsächlichen Bearbeitungskontur und der in der Steuereinrichtung abgespeicherten erwarteten Bearbeitungskontur, die nachfolgend auch "ideale" Bearbeitungskontur genannt wird.

Die geometrischen Abweichungen ihrerseits können sowohl Ursache einer ungenauen Einspannung des Werkstücks als auch Folge von Toleranzabweichungen sein, denen das Werkstück bei der Fertigung unterliegt. Folge dieser geometrischen Abweichungen ist, dass der Arbeitsfleck des Elektronenstrahls zwar der idealen Bearbeitungskontur richtig folgt, aber die reale Bearbeitungskontur dabei nicht oder nicht überall trifft. Eine zweite Ursache für Abweichungen zwischen dem Arbeitsfleck des Elektronenstrahls und der tatsächliche Bearbeitungskontur kann darin bestehen, dass in dem Werkstück eine Restmagnetisierung vorliegt, unter deren Einfluss der Elektronenstrahl abgelenkt wird. Dies hat zur Folge, dass der Arbeitsfleck des Elektronenstrahls sogar dann die tatsächliche Bearbeitungskontur nicht trifft, wenn diese der abgespeicherten idealen Bearbeitungskontur folgt. Diese magnetisch bedingten Abweichungen führen daher zu einem Verhalten, das jedenfalls vom Ergebnis her einer geometrischen Abweichung der tatsächlichen Bearbeitungskontur von der idealen Bearbeitungskontur gleichkommt. Eine weitere Ursache dafür, dass der Arbeitsfleck die tatsächliche Bearbeitungskontur nicht oder nicht überall trifft, kann in Fehlern bei der Bewegungsprogrammierung liegen.

Um sicherzustellen, dass der Arbeitsfleck des Elektronenstrahls überall auf die tatsächliche Bearbeitungskontur trifft, müsste dieser nach Steuergrössen gesteuert werden, die einer möglicherweise sowohl von der idealen als auch der tatsächlichen Bearbeitungskontur abweichenden Bearbeitungskontur entspricht, die hier "effektive" Bearbeitungskontur genannt wird. Scheidet eine magnetische Ablenkung des Elektronenstrahles aus, so entspricht die effektive Bearbeitungskontur der tatsächlichen Bearbeitungskontur.

Aufgabe der vorliegenden Erfindung ist es, ein Elektronenstrahl-Materialbearbeitungsverfahren der eingangs genannten Art so auszugestalten, dass die Abweichung der effektiven Bearbeitungskontur von der idealen Bearbeitungskontur leicht erfassbar dargestellt und so auch die Möglichkeit zur einfachen Korrektur dieser Abweichung gegeben ist.

Ein Materialbearbeitungsverfahren gemäß der Erfindung ist in Anspruch 1 definiert.

Wenn oben unter da) des Anspruchs 1 von "Betriebsparametern" gesprochen wird, dann sind damit insbesondere die Energiedichte im Arbeitsfleck des Elektronenstrahls und/oder die Geschwindigkeit der Relativbewegung zwischen dem Arbeitsfleck und dem Werkstück gemeint.

Unter "Steuergrößen" in Sinne des eingangs genannten Merkmals c) werden alle Parameter verstanden, welche die Steuerinrichtung zur Herbeiführung einer bestimmten Relativbewegung zwischen dem Focus des Elektronenstrahls und dem Werkstück erzeugt. Dabei handelt es sich insbesondere um die Größe und den zeitlichen Verlauf von Steuerströmen und/oder Steuerspannungen, die zur Ablenkung des Elektronenstrahls und/oder zur mechanischen Bewegung von Elektronenstrahl und/oder Werkstück verwendet werden.

Bei dem erfindungsgemäßen Verfahren wird eine Art "Abwicklung" der Bearbeitungskontur in der Weise erzeugt, dass unabhängig von dem tatsächlichen, im Allgemeinen gekrümmten Verlauf der Bearbeitungskontur die ideale Bearbeitungskontur immer als Gerade und die Abweichung der effektiven von der idealen Bearbeitungskontur immer als Abweichung von der Geradenform dargestellt wird. Dies ist insbesondere auch für un- oder nur angelernte Bedienungspersonen leicht erfassbar und stellt ausserdem eine Form dar, die sich für eine nachfolgenden Korrektur der Abweichungen besonders gut eignet.

Erfindungsgemäß wird die effektive Bearbeitungskontur, die sowohl geometrisch als auch magnetisch bedingte Abweichungen der "Auftreffspur" des Elektronenstrahles von der idealen Bearbeitungskontur auf dem Werkstück berücksichtigt, in derselben Einrichtung ermittelt, die auch das eigentliche Materialbearbeitungsverfahren durchführt. Dies bedeutet gegenüber einem lichtoptischen Verfahren zur Bestimmung der tatsächlichen Bearbeitungskontur einen mehrfachen Vorteil: Zum einen ist der apparative Aufwand sehr viel geringer, da im Allgemeinen alle erforderlichen Komponenten in der Elektronenstrahlanlage ohnehin vorhanden sind. Darüber hinaus ist das erfindungsgemäße Verfahren aber einem lichtoptischen Verfahren auch deshalb überlegen, weil der zur Bestimmung der effektiven Bearbeitungskontur eingesetzte Elektronenstrahl die Bearbeitungskontur so "sieht", wie dies der Elektronenstrahl auch bei der nachfolgenden eigentlichen Materialbearbeitung tut, so dass insbesondere auch magnetische Ablenkungen, die lichtoptisch nicht erfasst werden können, Berücksichtigung finden.

Das erfindungsgemäße Verfahren eignet sich besonders gut zum Verschweißen zweier Bauteile, bei dem also die Bearbeitungskontur eine Fuge zwischen zwei miteinander zu einem Werkstück zu verbindenden Bauteile ist.

An die Erfassung der Abweichungen der effektiven Bearbeitungskontur von der idealen Bearbeitungskontur nach Anspruch 1 lässt sich besonders einfach ein Korrekturschritt anschliessen, mit dem die Abweichungen für die thermische Behandlung korrigiert werden. Dieser zeichnet sich dadurch aus, dass nach dem Schritt d) von Anspruch 1
e) die der ermittelten effektiven Bearbeitungskontur entsprechenden Steuergrössen so eingestellt werden, dass der Arbeitsfleck des Elektronenstrahls beim Fortschritt der Relativbewegung in Richtung der effektiven Bearbeitungskontur überall auf dieser liegt;
f) danach die Relativbewegung zwischen dem Arbeitsfleck des Elektronenstrahls und dem Werkstück bei zur thermischen Behandlung geeigneten Betriebsparametern erneut durchgeführt wird.

Die Einstellung der Steuergrössen nach Schritt e) kann in vielen Fällen empirisch erfolgen, da nach kurzen Erfahrungen mit dem System aus der Form der ermittelten effektiven Bearbeitungskontur auf die Art der erforderlichen Korrektur der Steuergrössen geschlossen werden kann. In jedem Falle ist es nach jeder Korrektur der Steuergrössen leicht möglich zu erkennen, ob sich die (neue) effektive Bearbeitungskontur an die erwünschte Form einer Gerade angenähert hat oder nicht. Bei bestimmten charakteristischen Abweichungen können auch Algorithmen entwickelt werden, mit denen die Abweichungen auf ein tolerables Mass zurückgeführt werden können.

Die Relativbewegung zwischen dem Arbeitsfleck des Elektronenstrahls und dem Werkstück kann mechanisch durch Bewegung des Werkstücks und/oder der Elektronenstrahlquelle samt abbildenden Elementen erfolgen. Hierfür ist ein nicht unerheblicher apparativer Aufwand erforderlich; die Bewegung ist vergleichsweise träge.

Alternativ oder zusätzlich kann die Relativbewegung zwischen dem Arbeitsfleck des Elektronenstrahls und dem Werkstück elektrisch durch Ablenken des Elektronenstrahls erfolgen. Dies gelingt mit vergleichsweise geringem apparativen Aufwand und trägheitslos, unterliegt aber verständlicherweise geometrischen Grenzen. In jedem Falle ist es zweckmäßig, zumindest die Scan-Bewegung elektrisch durch entsprechende Ablenkung des Elektronenstrahls durchzuführen.

Wenn oben gesagt wurde, dass die Richtung der Scan-Bewegung "quer" zur Richtung der idealen Bearbeitungskontur liegen soll, so bedeutet dies nicht zwangsläufig einen rechten Winkel. In vielen Fällen wird zwar aus Gründen der Auswertung zweckmäßig sein, wenn die Richtung der Scanbewegung senkrecht auf der Tangente an den entsprechenden Punkt der idealen Bearbeitungskontur steht. Grundsätzlich kommen aber beliebige andere Winkel auch in Betracht.

Es kann vorkommen, dass beim Einspannen des Werkstücks eine verhältnismäßig grobe Fehlpositionierung erfolgt. In diesem Falle kann sich eine Verfahrensweise als nützlich erweisen, bei welcher vor der Bestimmung der effektiven Bearbeitungskontur (Merkmal d) in Anspruch 1) mit Hilfe des zurückgestreuten Elektronenstrahls ein Bild des Werkstücks erzeugt wird und dadurch Informationen über dessen Position in einem systemeigenenen Koordinatensystem erhalten werden und bei welcher dann Abweichungen dieser Position von einer Sollposition mechanisch oder elektronisch kompensiert werden. Grundsätzlich könnte man zwar ohne diese "Vorpositionierung" auskommen, wenn nur die Amplitude der Scan-Bewegung ausreichend groß wäre. Im Allgemeinen ist aber diese Amplitude aus bautechnischen Gründen limitiert, so dass vor der Ermittlung der effektiven Bearbeitungskontur die "Grobposition" des Werkstücks "zurechtgerückt" werden muss.

Als Ausführungsbeispiel der Erfindung wird nachfolgend anhand der Zeichnung die Verschweissung zweier Bauteile zu einem Werkstück näher erläutert; es zeigen:
- Figur 1: schematisch eine Anlage zum Elektronstrahl- schweißen;
- Figur 2: die Draufsicht auf ein Werkstück, das zwei miteinander zu verschweissende Bauteile umfasst;
- Figur 3: ebenfalls schematisch den Scan-Vorgang, wel- cher dem eigentlichen Elektronenstrahlschwei- ßen vorausgeht;
- Figur 4: das beim Scan-Vorgang gewonnene Signal an ei- ner Stelle, an welcher die vermessene, effektive Fuge mit dem programmierten, idealen Fugenverlauf übereinstimmt;
- Figur 5: das bei dem Scan-Vorgang gewonnene Signal an einer Stelle, an welcher die vermessene, effektive Fuge von dem programmierten, idealen Fugenverlauf abweicht;
- Figur 6: schematisch den "abgewickelten" effektiven Fugenverlauf vor einer Korrektur der Abweichungen vom idealen Fugenverlauf;
- Figur 7: schematisch den "abgewickelten" effektiven Fugenverlauf nach der Korrektur.

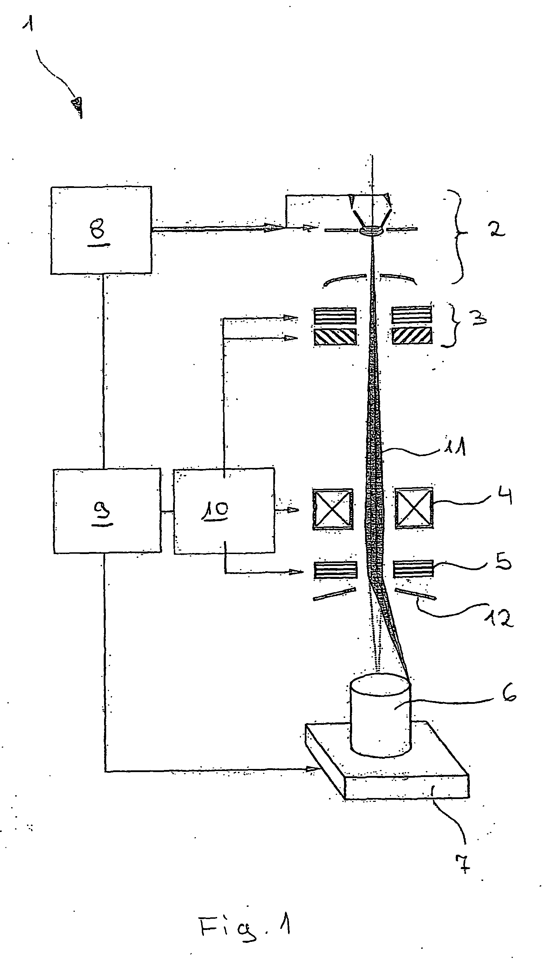

Zunächst wird auf Figur 1 Bezug genommen. Diese zeigt eine insgesamt mit dem Bezugszeichen 1 gekennzeichnete Anlage zum Elektronenstrahlschweißen, wie sie an und für sich bekannt ist. Es genügt daher, sie kurz zu beschreiben.

Die Anlage 1 umfasst in einem vakuumdichten, nicht dargestellten Gehäuse von oben nach unten eine Elektronenstrahlquelle 2, eine verschiedene Ablenkelektroden enthaltende Zentrier- und Stigmatoreinheit 3, eine geeignete Spulen umfassende Fokussierlinse 4, sowie x-y-Ablenkspulen 5. Das Werkstück 6 steht auf einem Manipulator 7, mit welchem es in der x-y-Ebene motorisch und hochpräzise bewegt werden kann.

In einer Steuereinrichtung 9 werden außerdem Ausgangssignale für verschiedene Verstärker 10 erzeugt, die ihrerseits wiederum an die Zentrier- und Stigmatoreinheit 3, an die Fokussierlinse 4, an die Ablenkspulen 5 sowie an den Manipulator 7 geeignete Ströme bzw. Spannungen anlegen.

Mit den verschiedenen, oben erwähnten Strömen oder Spannungen kann der Elektronenstrahl 11 auf das Werkstück 6 fokussiert und sein so entstandener Arbeitsfleck auf dem Werkstück 6 bewegt werden.

Unterhalb der Ablenkelektroden 5 sind Sensorplatten 12 angeordnet, die in der Lage sind, die vom Werkstück 6 zurückgestreuten Elektronen zu erfassen. Mit Hilfe der Sensorplatten 12 kann, wie dies im Stande der Technik bekannt ist, beispielsweise ein Bild von dem Werkstück 6 erzeugt werden, das einem optischen Bild durchaus ähnlich ist.

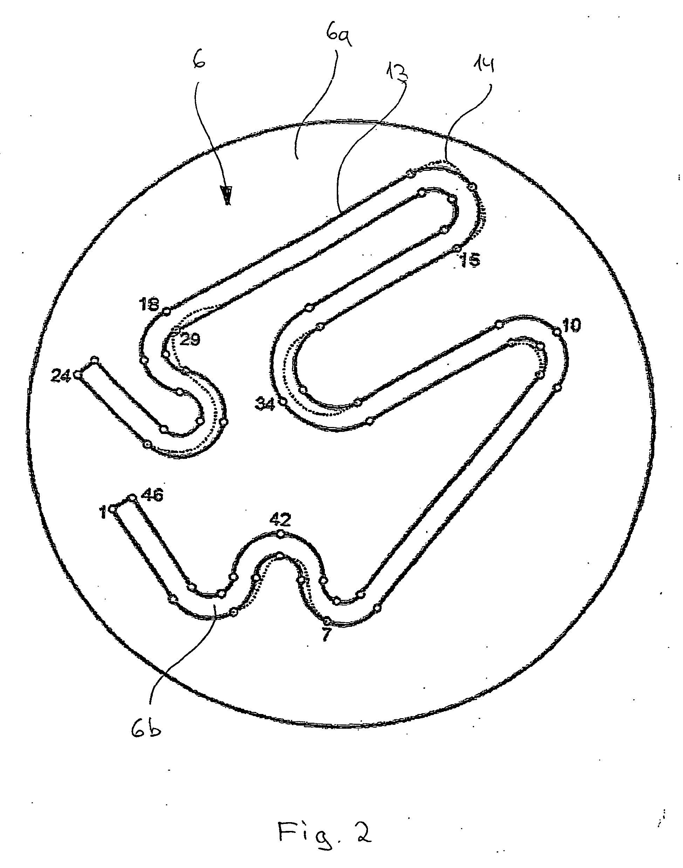

Unter Verwendung der oben anhand der Figur 1 erläuterten Anlage 1 lässt sich nunmehr das erfindungsgemäße Schweißverfahren wie nachfolgend beschrieben durchführen. Die Beschreibung erfolgt anhand eines beispielhaften Werkstücks 6, das in Figur 2 dargestellt ist und zwei miteinander zu verschweissende Bauteile 6a und 6b umfasst. Zwischen den beiden Bauteilen 6a, 6b liegt die ideale Schweissfuge 13, die im Falle des Schweissens die Bearbeitungskontur bildet und in der Steuereinrichtung 9 der Anlage 1 abgelegt ist. Aufgrund von Fehlern, wie sie oben geschildert wurden und weiter unten nocheinmal genauer erläutert werden, folgt der Arbeitsfleck des Elektronenstrahls 11 aber nicht dem idealen Fugenverlauf 13 sondern einem effektiven Fugenverlauf 14, der in den gepünktelt dargestellten Bereichen vom idealen Fugenverlauf 13 abweicht.

Entlang des idealen Fugenverlaufs 13 sind verschiedene Referenzpunkte 1 bis 46 angedeutet, die Beschreibungszwecken dienen.

Zunächst wird aus dem an dem Werkstück 6 zurückgestreuten Elektronenstrahl 11 ein Bild- oder Teilbild des Werkstückes 6 erzeugt, das eine Bestimmung der groben Position des Werkstückes 6 in dem systemeigenen Koordinatenstystem der Anlage 1 ermöglicht. Weicht diese erheblich von einer eingespeicherten Sollposition ab, wird das Werkstück 6 mit Hilfe des Manipulators 7 näher an die Sollposition herangeschoben.

Nun wird die eigentlichen Schweißung in folgender Weise vorbereitet:

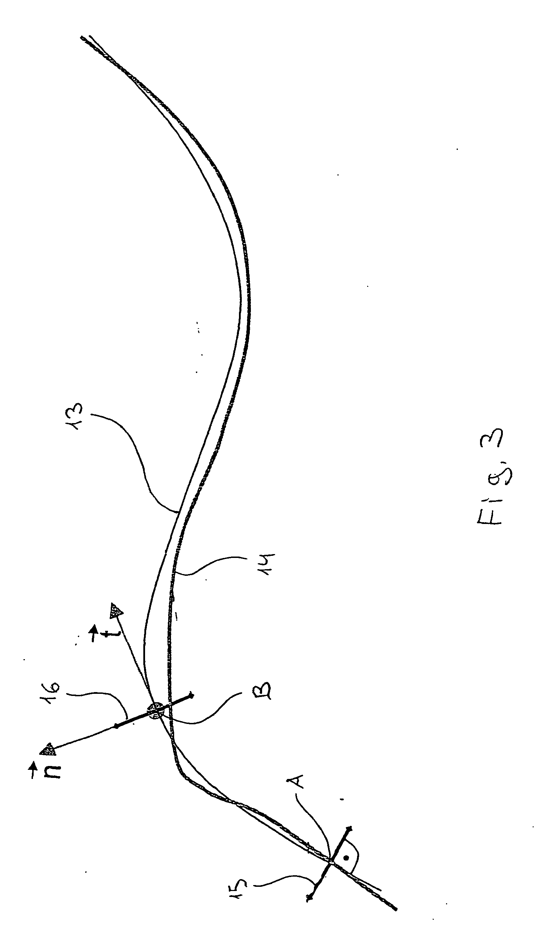

In Figur 3 ist mit der relativ dünnen Linie 13 ein Ausschnitt des idealen Fugenverlaufs zwischen den beiden miteinander zu verschweißenden Bauteilen 6a, 6b dargestellt, der, wie oben schon erwähnt, in geeigneter Weise in der Steuereinrichtung 9 einprogrammiert ist. Mit der etwas dickeren Linie 14 ist der entsprechende Ausschnitt des "effektiven" Fugenverlaufs dargestellt, der aufgrund verschiedener Einflüsse von dem idealen Fugenverlauf 13 abweicht. Sehr häufig beruhen derartige Abweichungen auf echten geometrischen Abweichungen des realen Fugenverlaufs, die ihrerseits ihre Ursache in einer fehlerhaften Einspannung des Werkstückes 6 auf dem Manipulator 7 oder in Fertigungstoleranzen der miteinander zu verschweißenden Bauteile 6a, 6b liegen können. Die Abweichung des effektiven Fugenverlaufs 14 von dem idealen Fugenverlauf 13 kann jedoch auch nichtgeometrische Gründe haben, nämlich dann, wenn der Elektronenstrahl 11 bei magnetischen Bauteilen 6a, 6b durch einen vorhandenen Restmagnetismus so abgelenkt wird, dass die ideale Fuge 13 vom Elektronenstrahl 11 nicht richtig getroffen wird.

Zur Ermittlung des effektiven Fugenverlaufs 14 wird in einem dem eigentlichen Schweißvorgang vorgeschalteten Scan-Vorgang wie folgt verfahren:

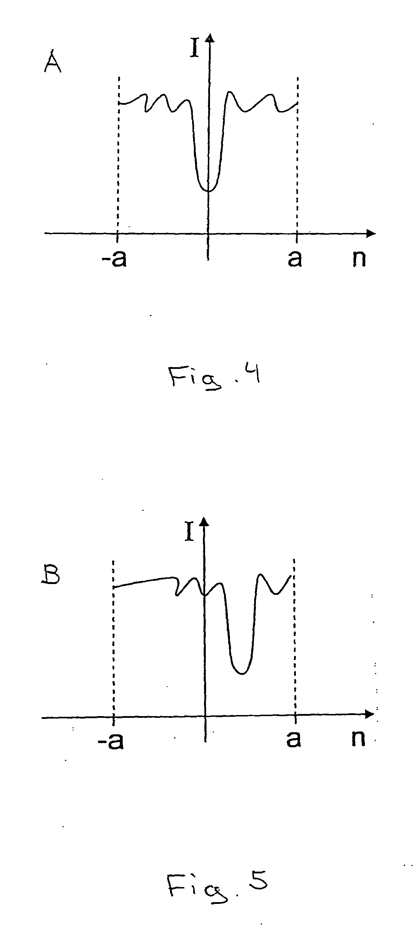

Der Arbeitsfleck des Elektronenstrahles 11 wird mit verminderter Energiedichte und/oder höherer Geschwindigkeit, die zum Schweißen nicht ausreicht, entlang des idealen Fugenverlaufs 13 bewegt, wobei dieser Vorschubbewegung eine senkrecht zur jeweiligen Tangentialrichtung des idealen Fugenverlaufs 13 verlaufende Scan-Bewegung 15 bzw. 16 überlagert wird. Diese Scan-Bewegung 15 bzw. 16 reicht beidseits über den "idealen" Fugenverlauf 13 um eine Amplitude a (vgl. Figuren 3 und 4) hinaus. Während der Vorschub- und der Scan-Bewegung 15 bzw. 16 des Elektronenstrahles 11 wird mit Hilfe der Sensorplatten 12 der Anlage 1 ein Intensitätssignal aufgenommen. Dabei ergeben sich als Funktion der Auslenkung des Arbeitsflecks von dem idealen Fugenverlauf 13 bestimmte Intensitätsschwankungen, wie sie in den Figuren 4 und 5 dargestellt sind.

Zunächst sei in Figur 3 die Stelle A des idealen Fugenverlaufs 13 betrachtet, an welcher der ideale Fugenverlauf 13 mit dem effektiven Fugenverlauf 14 übereinstimmt.
In diesem Falle sieht der Verlauf der mit Hilfe der Sensorplatten 12 ermittelten Intensität des zurückgestreuten Elektronenstrahles 11 so aus, wie in Figur 4 dargestellt. Ein ausgeprägtes Minimum liegt an der Stelle "null", also an der Stelle, an welcher die Scan-Bewegung 15 des Elektronenstrahles 11 gerade den "idealen" Fugenverlauf 13 kreuzt.

Anders dagegen an der Stelle B in Figur 3, an welcher der ideale Fugenverlauf 13 von dem effektiven Fugenverlauf 14 deutlich abweicht. Das an dieser Stelle mit Hilfe der Sensorplatten 12 gewonnene Intensitätssignal ist in Figur 5 dargestellt. Auch in diesem Falle tritt ein deutliches Minimum der Intensität auf, das aber seitlich neben derjenigen Stelle sitzt, an welcher der Arbeitsfleck des Elektronenstrahles 11 über den idealen Fugenverlauf 13 läuft.

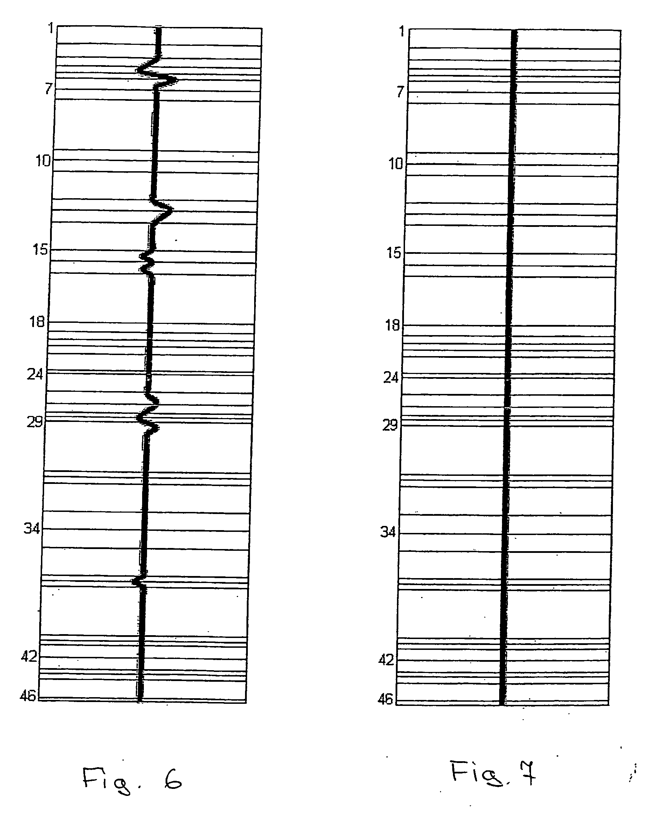

Zur leicht erfassbaren Darstellung des effektiven Fugenverlaufs 14 werden nicht die Intensitätskurven, wie in den Figuren 4 und 5 gezeigt, verwendet. Vielmehr wird eine Darstellung gewählt, die einem Bild des Werkstückes 6 in der Umgebung des idealen Fugenverlaufs 13 entspricht. Hierzu werden beispielsweise die Intensitätsverläufe nach den Figuren 4 und 5 in Grauwerte umgesetzt. Die bei den verschiedenen Scanbewegungen erhaltenen Grauwerte werden in einer Weise aneinander gesetzt, wie dies in Figur 6 dargestellt ist. Diese Figur zeigt insbesondere die Grauwertverteilungen an den 46 Referenzpunkten der Figur 2. Die Lage des effektiven Fugenverlaufs 14 ist durch eine breite dunkle Linie erkennbar.

Aufgrund der oben anhand der Figur 3 geschilderten Vorgehensweise bei dem Scan-Vorgang ergibt sich eine Art Abwicklung des effektiven Fugenverlaufs 14. Stimmt dieser überall mit dem idealen Fugenverlauf 13 überein, ergibt sich immer, also unabhängig von der geometrischen Führung des idealen Fugenverlaufs 13 auf dem Werkstück 6, als Bild eine Gerade, wie dies in Figur 7 gezeigt ist. Abweichungen des effektiven Fugenverlaufs 14 von dem idealen Fugenverlauf 13 äußern sich in entsprechenden Abweichungen des Bildes von der Geradenform, wie in Figur 6 gezeigt.

Es ist offensichtlich, dass die als Ergebnis des Scan-Vorgangs erhaltenen Bilder eine sehr rasche und leicht zu verstehende Auswertung gestatten, gerade auch deshalb, weil die Grundform des idealen Fugenverlaufs 13 im Bild unabhängig vom tatsächlichen geometrischen Fugenverlauf auf dem Werkstück 6 immer eine Gerade und eine Abweichung des effektiven Fugenverlaufs 14 vom idealen Fugenverlauf 13 im Bild immer eine Abweichung vorn der Geradenform ist.

Diese "Standardisierung" der bildhaften Darstellung des "abgewickelten" effektiven Fugenverlaufs 14 erleichtert auch die Korrektur der Steuergrössen der Steuereinrichtung 9 in der Weise, dass die Abweichungen des effektiven Fugenverlaufs 14 von dem idealen Fugenverlauf 13 zurückgeführt werden. Hier reichen häufig empirische Erkenntisse aus, um erfolgreiche Änderungen der Steuergrössen durchführen zu können. Ein nach einer solchen Änderung durchgeführter weiterer Scan-Vorgang macht sofort klar, ob die vorgenommenen Korrekturen der Steuergrössen in die richtige Richtung gingen oder nicht, ob also die bildhafte Darstellung des effektiven Fugenverlaufs 14 sich besser an die Geradenform angenähert hat oder nicht.

In manchen Fällen ist es auch möglich, bestimmten Formen der Abweichungen des effektiven Fugenverlaufs 14 von dem idealen Fugenverlauf 13 einen Algorithmus zuzuordnen, mit dem sich die neuen Steuergrössen errechnen lassen, die sich zu einer Korrektur der Führung des Elektronenstrahls 11 eigenen.

Ist der geschilderte Scan-Vorgang abgeschlossen und sind die zur Korrektur geeigneten neuen Steuergrössen in der Steuereinrichung 9 eingestellt, kann der Elektronenstrahl 11 nunmehr mit ausreichender Energiedichte im Arbeitsfleck und/oder entsprechend geringerer Geschwindigkeit zum eigentlichen Schweißvorgang problemlos entlang des effektiven Fugenverlaufs 14 geführt werden, so dass die beidseits des effektiven Fugenverlaufs 14 liegenden Bauteile 6a, 6b hoch präzise miteinander verbunden werden können.

Die Relativbewegung zwischen Arbeitsfleck des Elektronenstrahls 11 und dem Werkstück 6 kann statt elektronisch durch Ablenkung des Elektronenstrahls auch durch mechanische Bewegung des Werkstücks 6 auf dem Manipulator 7 oder auch durch mechanische Bewegung der Elektronenstrahlquelle 2 mit den zugehörigen abbildenden Elementen 3, 4, 5, 12 erfolgen.

Wie oben schon erwähnt, ist das Verschweissen zweier Bauteile nur ein Beispiel eines thermischen Materialbearbeitungsverfahrens. Die Vorgehensweise bei anderen Verfahren ist jedoch grundsätzlich dieselbe, wobei dann in der obigen Beschreibung der allgemeinere Begriff der "Bearbeitungskontur" an die Stelle des spezielleren Begriffes "Fugenverlauf" tritt.

Die obige Beschreibung der Erfindung erfolgte an einem Beispiel, bei dem Abweichungen der effektiven Bearbeitungskontur von der idealen Bearbeitungskontur nur in einer Richtung vorlagen. Das erfindungsgmäße Verfahren eignet sich jedoch auch für Fälle, bei denen auch in einer weiteren Richtung Abweichungen der effektiven von der idealen Bearbeitungskontur vorliegen. Derartige Abweichungen äußern sich in lokalen Unschärfen des Bildes nach den Figuren 6 oder 7. Die Korrektur in dieser Richtung erfolgt so, dass diese Bilder über ihre gesamte Erstreckung hinweg scharf werden.

## Patentansprüche

1. Thermisches Materialbearbeitungsverfahren, bei dem
a) ein Elektronenstrahl auf die Oberfläche eines Werkstücks fokussiert wird;
b) zwischen dem Arbeitsfleck des Elektronenstrahls und dem Werkstück eine Relativbewegung bewirkt wird, bei welcher der Arbeitsfleck einer Bearbeitungskontur folgt;
**dadurch gekennzeichnet, dass**
c) die Relativbewegung zwischen Arbeitsfleck und Werkstück nach Steuergrößen gesteuert wird, die eine Steuereinrichtung aus einer abgespeicherten idealen Bearbeitungskontur ableitet;
d) vor dem eigentlichen Bearbeitungsvorgang eine Bestimmung einer effektiven Bearbeitungskontur (14) erfolgt, indem
da) der Arbeitsfleck des Elektronenstrahls (11) nach den gespeicherten Daten der idealen Bearbeitungskontur (13) mit Betriebsparametern, die zur thermischen Behandlung nicht ausreichen, eine Relativbewegung gegenüber dem Werkstück (6) ausführt;
db) dieser der idealen Bearbeitungskontur (13) entsprechenden Relativbewegung an einer Vielzahl von Punkten eine Scan-Bewegung überlagert wird, die quer zur idealen Bearbeitungskontur (13) gerichtet ist und beidseits über diese hinausreicht;
dc) die Intensität des von dem Werkstück (6) zurückgestreuten Elektronenstrahls (11) in Abhängigkeit von der Auslenkung der Scan-Bewegung gemessen wird;
dd) die im Schritt dc) ermittelten Intensitätsabhängigkeiten, die bei den verschiedenen Scan-Bewegungen gemessen wurden, so nebeneinander gesetzt werden, dass sich eine bildhafte Darstellung des Werkstücks (6) ergibt, bei welcher auf der einen Achse der Fortschritt der Relativbewegung in Richtung der Bearbeitungskontur (13) und in einer zweiten Achse die Abweichung der effektiven Bearbeitungskontur (14) von der idealen Bearbeitungskontur (13) aufgetragen ist.

2. Materialbearbeitungsverfahren nach Anspruch 1, **dadurch gekennzeichnet, dass** die Bearbeitungskontur (13, 14) eine Fuge zwischen zwei miteinander zu einem Werkstück (6) zu verbindenden Bauteilen (6a, 6b) ist.

3. Materialbearbeitungsverfahren nach Anspruch 1 oder 2, **dadurch gekennzeichnet, dass** nach dem Schritt dd) von Anspruch 1
e) die der ermittelten effektiven Bearbeitungskontur (14) entsprechenden Steuergrössen so eingestellt werden, dass der Arbeitsfleck des Elektronenstrahles (11) beim Fortschritt der Relativbewegung in Richtung der effektiven Bearbeitungskontur (14) überall auf dieser liegt;
f) danach die Relativbewegung zwischen dem Arbeitsfleck des Elektronenstrahls (11) und dem Werkstück bei zur thermischen Behandlung geeigneten Betriebsparametern erneut durchgeführt wird.

4. Materialbearbeitungsverfahren nach einem der Ansprüche
1 bis 3, **dadurch gekennzeichnet, dass** die Relativbewegung zwischen dem Arbeitsfleck des Elektronenstrahls (11) und dem Werkstück (6) mechanisch durch Bewegung des Werkstücks und/oder der Elektronenstrahlquelle (2) samt den abbildenden Elementen (3, 4, 5) erfolgt.

5. Materialbearbeitungsverfahren nach einem der Ansprüche
1 bis 3, **dadurch gekennzeichnet, dass** die Relativbewegung zwischen dem Arbeitsfleck des Elektronenstrahls (11) und dem Werkstück (6) elektrisch durch Ablenken des Elektronenstrahls (11) erfolgt.

6. Materialbearbeitungsverfahren nach einem der Ansprüche vorhergehenden Ansprüche, **dadurch gekennzeichnet, dass** die Richtung der Scan-Bewegung senkrecht auf der Tangente an den entsprechenden Punkt der idealen Bearbeitungskontur (13) steht.

7. Materialbearbeitungsverfahren nach einem der Ansprüche vorhergehenden Ansprüche, **dadurch gekennzeichnet, dass** vor der Bestimmung der effektiven Bearbeitungskontur (14) im (Merkmal d) in Anspruch 1 mit Hilfe eines zurückgestreuten Elektronenstrahls ein Bild des Werkstücks (6) erzeugt wird und damit Informationen über dessen Position innerhalb eines systemeigenen Koordinatensystemes gewonnen werden und dass dann Abweichungen dieser Position von einer Sollposition mechanisch oder elektrisch kompensiert werden.

## Claims

1. Thermal material-processing method wherein
a) an electron beam is focused onto the surface of a workpiece;
b) between the working spot of the electron beam and the workpiece a relative motion is brought about, in the course of which the working spot follows a processing contour;
**characterised in that**
c) the relative motion between working spot and workpiece is controlled in accordance with control variables that a control device derives from a stored ideal processing contour;
d) prior to the actual processing operation a determination of the effective processing contour (14) is undertaken, **in that**
da) the working spot of the electron beam (11) executes a relative motion in relation to the workpiece (6) in accordance with the stored data of the ideal processing contour (13) with operating parameters that do not suffice for thermal treatment;
db) on this relative motion corresponding to the ideal processing contour (13) there is superimposed at a plurality of points a scan motion which is directed transversely to the ideal processing contour (13) and reaches beyond the latter on both sides;
dc) the intensity of the electron beam (11) back-scattered from the workpiece (6) is measured as a function of the deflection of the scan motion;
dd) the intensity dependences ascertained in step dc), which were measured in the course of the various scan motions, are placed side by side in such a way that a graphical representation of the workpiece (6) arises in which the progress of the relative motion in the direction of the processing contour (13) is plotted on one axis and the deviation of the effective processing contour (14) from the ideal processing contour (13) is plotted in a second axis.

2. Material-processing method according to Claim 1, **characterised in that** the processing contour (13, 14) is a groove between two structural components (6a, 6b) to be joined together so as to form a workpiece (6).

3. Material-processing method according to Claim 1 or 2, **characterised in that**, after step dd) of Claim 1,
e) the control variables corresponding to the ascertained effective processing contour (14) are set in such a way that in the course of the progress of the relative motion in the direction of the effective processing contour (14) the working spot of the electron beam (11) lies everywhere on said contour;
f) the relative motion between the working spot of the electron beam (11) and the workpiece is then implemented again with operating parameters that are suitable for thermal treatment.

4. Material-processing method according to one of Claims 1 to 3, **characterised in that** the relative motion between the working spot of the electron beam (11) and the workpiece (6) is effected mechanically by motion of the workpiece and/or of the electron-beam source (2) together with the imaging elements (3, 4, 5).

5. Material-processing method according to one of Claims 1 to 3, **characterised in that** the relative motion between the working spot of the electron beam (11) and the workpiece (6) is effected electrically by deflecting the electron beam (11).

6. Material-processing method according to one of the preceding claims, **characterised in that** the direction of the scan motion is perpendicular to the tangent to the corresponding point of the ideal processing contour (13).

7. Material-processing method according to one of the preceding claims, **characterised in that** prior to the determination of the effective processing contour (14) in (feature d) in Claim 1 with the aid of a back-scattered electron beam an image of the workpiece (6) is generated and thereby information is obtained about the position thereof in a system-specific coordinate system, and **in that** deviations of this position from a specified position are then compensated mechanically or electrically.

## Revendications

1. Procédé d'usinage thermique de matériaux, dans lequel
a) un faisceau d'électrons est focalisé vers la surface d'une pièce usinée ;
b) un mouvement relatif est provoqué entre ladite pièce et la zone opérante dudit faisceau d'électrons, mouvement au cours duquel ladite zone opérante suit un profil d'usinage ;
**caractérisé par le fait**
c) **que** le mouvement relatif, entre la zone opérante et la pièce, est piloté d'après des grandeurs de commande qu'un dispositif de commande dérive sur la base d'un profil d'usinage idéal mémorisé ;
d) **que** la détermination d'un profil d'usinage (14) effectif s'opère préalablement au processus d'usinage proprement dit, en ce sens
da) que ladite zone opérante du faisceau d'électrons (11) accomplit un mouvement relatif vis-à-vis de la pièce (6), d'après les données mémorisées du profil d'usinage (13) idéal, avec des paramètres fonctionnels non suffisants pour le traitement thermique ;
db) qu'un mouvement de balayage exploratoire venant se superposer, en une multiplicité de points, à ce mouvement relatif correspondant au profil d'usinage (13) idéal, est dirigé transversalement par rapport audit profil d'usinage (13) idéal et dépasse, de part et d'autre, au-delà de ce dernier ;
dc) que l'intensité dudit faisceau d'électrons (11), rétrodiffusé par ladite pièce (6), est mesurée en fonction de l'excursion dudit mouvement de balayage exploratoire ;
dd) que les dépendances de l'intensité, établies à l'étape dc) et ayant été mesurées au cours des différents mouvements de balayage exploratoire, sont mutuellement juxtaposées de façon telle qu'il en résulte une représentation imagée de ladite pièce (6) dans laquelle la progression du mouvement relatif, dans la direction du profil d'usinage (13), est portée sur l'un des axes, et l'écart du
profil d'usinage (14) effectif, par rapport au profil d'usinage (13) idéal, est porté sur un second axe.

2. Procédé d'usinage thermique de matériaux, selon la revendication 1, **caractérisé par le fait que** le profil d'usinage (13, 14) est une jonction entre deux éléments structurels (6a, 6b) devant être assemblés en une pièce (6).

3. Procédé d'usinage thermique de matériaux, selon la revendication 1 ou 2, **caractérisé par le fait qu'**à l'issue de l'étape dd) de la revendication 1,
e) les grandeurs de commande, correspondant au profil d'usinage (14) effectif établi, sont réglées de telle manière que la zone opérante du faisceau d'électrons (11) soit en tous points située sur ledit profil d'usinage (14) effectif, au cours de la progression du mouvement relatif dans la direction de ce dernier ;
f) le mouvement relatif, entre la pièce et ladite zone opérante du faisceau d'électrons (11), est ensuite réitéré en présence de paramètres fonctionnels appropriés pour le traitement thermique.

4. Procédé d'usinage thermique de matériaux, selon l'une des revendications 1 à 3, **caractérisé par le fait que** le mouvement relatif, entre la pièce (6) et la zone opérante du faisceau d'électrons (11), s'opère mécaniquement par mouvement de ladite pièce et/ou de la source (2) de faisceaux d'électrons, conjointement aux éléments (3, 4, 5) de formation d'images.

5. Procédé d'usinage thermique de matériaux, selon l'une des revendications 1 à 3, **caractérisé par le fait que** le mouvement relatif, entre la pièce (6) et la zone opérante du faisceau d'électrons (11), s'opère électriquement par déviation dudit faisceau d'électrons (11).

6. Procédé d'usinage thermique de matériaux, selon l'une des revendications précédentes, **caractérisé par le fait que** la direction du mouvement de balayage exploratoire est perpendiculaire à la tangente au point correspondant du profil d'usinage (13) idéal.

7. Procédé d'usinage thermique de matériaux, selon l'une des revendications précédentes, **caractérisé par le fait qu'**une image de la pièce (6) est engendrée à l'aide d'un faisceau d'électrons rétrodiffusé, préalablement à la détermination du profil d'usinage (14) effectif suivant la caractéristique d) de la revendication 1, des informations étant ainsi acquises quant à l'emplacement de ladite pièce au sein d'un système de coordonnées natif ; et **par le fait que** des écarts de cet emplacement, vis-à-vis d'un emplacement de consigne, sont ensuite compensés mécaniquement ou électriquement.
